# EUROPEAN PATENT APPLICATION

(11) **EP 4 524 935 A1**
(43) Date of publication of application: **19.03.2025**
(21) Application number: 24161432.0
(22) Date of filing: 05.03.2024
(51) Int. Cl.: G09B 9/04, F16H 1/28, F16H 57/08

(54) **AUTOMOBILE STEERING SIMULATOR STUCTURE**

(30) Priority: 15.09.2023 CN 202311200273
(71) Applicant: Shenzhen Cammus Electronic Technology Co.,Ltd, 518000 Guangdong (CN)
(72) Inventor: JIAN, HU, Guangdong, 518000 (CN)
(74) Representative: Sánchez Margareto, Carolina

(57) **Abstract**

The present application discloses an automobile steering simulator structure, comprising a simulator, a coupling and a steering wheel, wherein the coupling is fixedly connected to an output end of the simulator, and the steering wheel is fixedly connected to one end of the coupling, wherein a back cover is nested at a bottom of the simulator, a plurality of installation holes are provided at the bottom of the simulator, and a DC power interface and a USB interface are arranged in a middle of the back cover, wherein a first cavity and a second cavity are fixedly provided inside the simulator.

## Description

### TECHNICAL FIELD

The present application relates to a steering simulator, in particular to an automobile steering simulator structure, and belongs to the field of automobile technology.

### BACKGROUND

In the field of automobile and racing simulators, traditional non-direct drive simulators usually use small torque motors and reduce transmission through gears or belts to increase torque. Gear transmission will vibrate due to gear clearance, which will interfere with the simulator's steering feel transmission; while belt transmission will weaken the high-frequency part of the steering feel due to its flexibility, which will affect the experience.

### SUMMARY OF THE APPLICATION

The purpose of the present application is to provide an automobile steering simulator structure to solve the problems raised in the above background art.

In order to achieve the above purpose, the present application provides the following technical solutions: comprising simulator, coupling and steering wheel, wherein the coupling is fixedly connected to an output end of the simulator, and the steering wheel is fixedly connected to one end of the coupling, wherein a back cover is nested at a bottom of the simulator, a plurality of installation holes are provided at the bottom of the simulator, and a DC power interface and a USB interface are arranged in a middle of the back cover, wherein a first cavity and a second cavity are fixedly provided inside the simulator, wherein a PCBA board and a motor are fixedly arranged inside the first cavity, a planet assembly is fixedly arranged inside the second cavity, and the motor is fixedly connected to an input end of the planet assembly, and the DC power interface and USB interface are electrically connected to the PCBA board.

As a preferred technical solution of the present application, the planet assembly consists of a first planet carrier, a second planet carrier, a planet carrier support column and a planet deceleration mechanism, wherein the plurality of planet carrier support columns are fixed between the first planet carrier and the second planet carrier, and the plurality of planet carrier support columns are fixed to the first planet carrier and the second planet carrier by bolts, and a planet reduction mechanism is fixedly arranged between the first planet carrier and the second planet carrier.

As a preferred technical solution of the present application, a planet ring is connected to an outside of the first planet carrier and the second planet carrier, wherein two bearings are arranged between the first planet carrier, the second planet carrier and the planet ring.

As a preferred technical solution of the present application, the planet reduction mechanism comprises a sun gear, two tension springs, a first transmission shaft, a first planet gear, a second transmission shaft, a second planet gear, a third transmission shaft and a third planet gear, wherein the sun gear is rotatably connected to a center of the second planet carrier, wherein the first transmission shaft and the third transmission shaft that are transitionally assembled and connected to the second planet carrier, and the second transmission shaft assembled with a large gap to the second planet carrier are fixed in sequence on sides of the sun gear, wherein the first planet gear is rotatably connected to a middle of the first transmission shaft, the second planet gear is rotatably connected to a middle of the second transmission shaft, and the third planet gear is rotatably connected to a middle of the third transmission shaft, wherein a tension spring is fixedly connected between the second transmission shaft, the first transmission shaft and the third transmission shaft respectively.

As a preferred technical solution of the present application, the tension spring provides a certain preload force between the first planet gear, the second planet gear, the third planet gear and the sun gear, so that they are in contact with each other, and through a friction transmission between them, the power is transmitted from the sun gear to the planet ring or the planet carrier, wherein the first planet gear, the second planet gear, and the third planet gear have different diameters.

As a preferred technical solution of the present application, an output shaft is fixedly arranged on a top of the second planet carrier, and a bearing is arranged between the output shaft and the planet ring wherein an external circlip is arranged axially on the output shaft and the bearing.

As a preferred technical solution of the present application, a motor flange is provided inside the first cavity to be fixed to the planet ring, the motor is fixedly connected to the motor flange, and an output end of the motor is fixedly connected to a center of the sun gear.

As a preferred technical solution of the present application, the first planet gear, the second planet gear, the third planet gear, and the planet ring are made of metal or other hard materials, and the surfaces where they contact each other have hardness and wear resistance requirements.

Compared with the existing technology, the beneficial effects of the present application are: Using this car steering simulator, the steering road feel is transmitted directly, and the transmission torque is large without delay or jitter, which solves the pain points of traditional non-direct drive steering simulators. The structure of this application is simple, and the system cost is lower than traditional non-direct drive simulator.

### BRIEF DESCRIPTION OF THE DRAWINGS

Fig. 1 is a schematic structural diagram of the automobile steering simulator structure according to the present application.
Fig. 2 is a schematic front structural view of the automobile steering simulator structure according to the first embodiment of the present application.
Fig. 3 is a schematic side structural view of the automobile steering simulator structure according to the first embodiment of the present application.
Fig. 4 is a schematic cross-sectional internal structure diagram of the automobile steering simulator structure according to the first embodiment of the present application.
Fig. 5 is a schematic diagram of the planet carrier connection structure of the automobile steering simulator structure according to the present application.
Fig. 6 is a schematic diagram of the connection structure between the planet ring and the planet carrier of the automobile steering simulator structure according to the present application.
Fig. 7 is a schematic structural diagram of the planet reduction mechanism of the automobile steering simulator structure according to the present application.
Fig. 8 is a schematic front structural view of the automobile steering simulator structure according to the second embodiment of the present application.
Fig. 9 is a schematic cross-sectional structural diagram of the automobile steering simulator structure according to the second embodiment of the present application.

### Reference signs:

1. Simulator; 2. Coupling; 3. Steering wheel; 4. Planet ring; 5. Back cover; 6. Installation hole; 7. DC power interface; 8. USB interface; 9. Output shaft; 10. PCBA board; 11. First cavity; 12. Motor; 13. Second cavity; 14. Motor flange; 15. First planet carrier; 16. Second planet carrier; 17. Bearing; 18. External circlip; 19 , Planet carrier support column; 20. Sun gear; 21. Tension spring; 22. First transmission shaft; 23. First Planet gear; 24. Second transmission shaft; 25. Second planet gear; 26. Third transmission shaft; 27. Third planet wheel; 28. Gasket; 29. Bolts.

### DETAILED DESCRIPTION

The technical solutions in the embodiments of the present application will be clearly and completely described below in conjunction with the accompanying drawings in the embodiments of the present application. Obviously, the described embodiments are only some of the embodiments of the present application, but not all of the embodiments. Based on the embodiments in the present application, all other embodiments obtained by those of ordinary skill in the art without creative efforts fall within the protection scope of the present application.

### FIRST EMBODIMENT

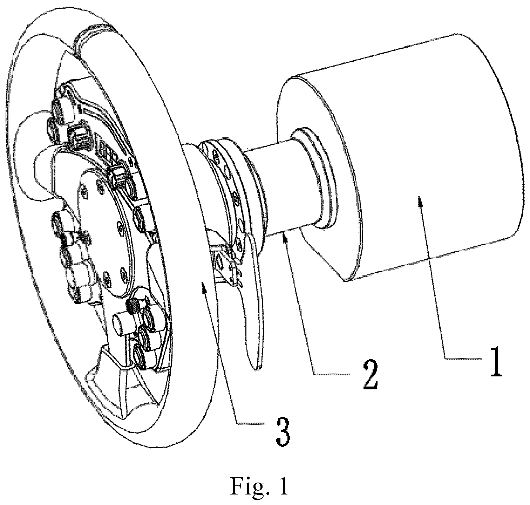

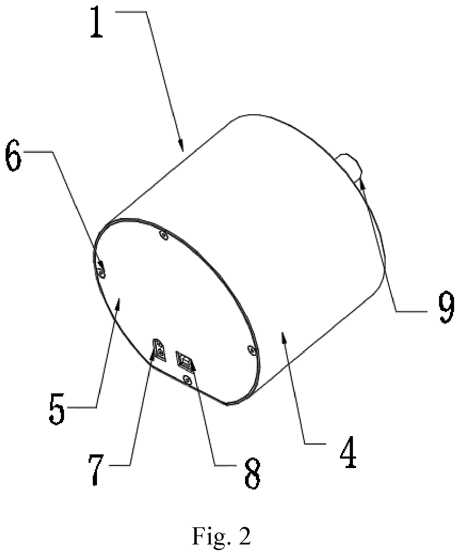

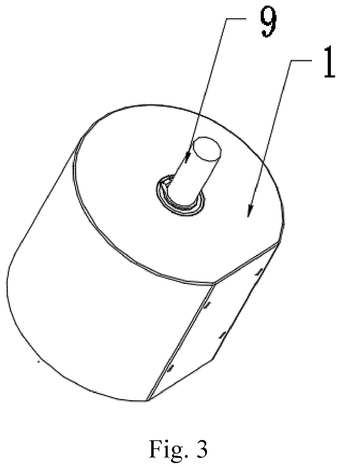

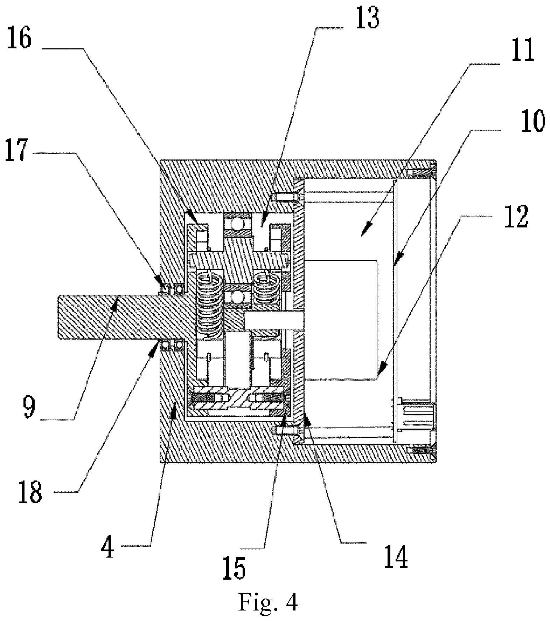

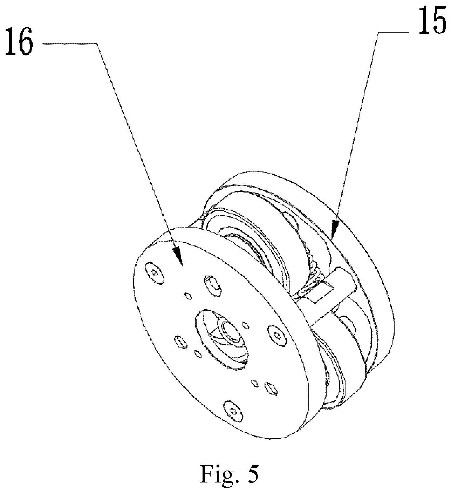

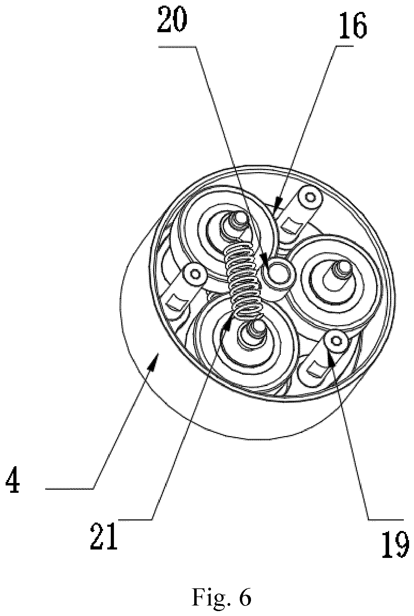

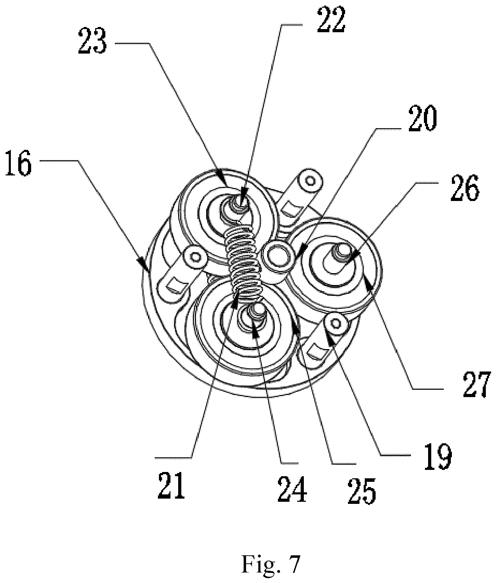

Please refer to Fig. 1-7, the present application provides a technical solution for an automobile steering simulator structure:

As shown in Fig. 1-7, it comprises a simulator 1, a coupling 2 and a steering wheel 3, wherein the coupling 2 is fixedly connected to an output end of the simulator 1, and the steering wheel 3 is fixedly connected to one end of the coupling 2, wherein a back cover 5 is nested at a bottom of the simulator 1, a plurality of installation holes 6 are provided at the bottom of the simulator 1, and a DC power interface 7 and a USB interface 8 are arranged in a middle of the back cover 5, wherein a first cavity 11 and a second cavity 13 are fixedly provided inside the simulator, wherein a PCBA board 10 and a motor 12 are fixedly arranged inside the first cavity 11, a planet assembly is fixedly arranged inside the second cavity 13, and the motor 12 is fixedly connected to an input end of the planet assembly, and the DC power interface 7 and USB interface 8 are electrically connected to the PCBA board 10.

As shown in Fig. 1-7, the planet assembly consists of a first planet carrier 15, a second planet carrier 16, a planet carrier support column 19 and a planet deceleration mechanism, wherein the plurality of planet carrier support columns 19 are fixed between the first planet carrier 15 and the second planet carrier 16, and the plurality of planet carrier support columns 19 are fixed to the first planet carrier 15 and the second planet carrier 16 by bolts, and a planet reduction mechanism is fixedly arranged between the first planet carrier 15 and the second planet carrier 16.

A planet ring 4 is connected to an outside of the first planet carrier 15 and the second planet carrier 16, wherein two bearings 17 are arranged between the first planet carrier 15, the second planet carrier 16 and the planet ring 4.

The planet reduction mechanism comprises a sun gear 20, two tension springs 21, a first transmission shaft 22, a first planet gear 23, a second transmission shaft 24, a second planet gear 25, a third transmission shaft 26 and a third planet gear 27, wherein the sun gear 20 is rotatably connected to a center of the second planet carrier 16, wherein the first transmission shaft 22 and the third transmission shaft 26 that are transitionally assembled and connected to the second planet carrier 16, and the second transmission shaft 24 assembled with a large gap to the second planet carrier 16 are fixed in sequence on sides of the sun gear 20, wherein the first planet gear 23 is rotatably connected to a middle of the first transmission shaft 22, the second planet gear 25 is rotatably connected to a middle of the second transmission shaft 24, and the third planet gear 27 is rotatably connected to a middle of the third transmission shaft 26, wherein a tension spring 21 is fixedly connected between the second transmission shaft 24, the first transmission shaft 22 and the third transmission shaft 26 respectively.

Tension springs 21 are arranged between the first planet gear 23 and the second planet gear 25 and between the second planet gear 25 and the third planet gear 27 to provide a certain preload force between the three planet gears, the sun gear 20 and the planet ring 4, so that the three planet gears, the sun gear 20 and the planet ring 4 contact each other and provide sufficient friction.

The first planet gear 23 , the second planet gear 25, the third planet gear 27 and the sun gear 20 are in contact with each other, and the first planet gear 23 , the second planet gear 25, and the third planet gear 27 have different diameters. The configuration of the first planet gear23, the second planet gear 25 and the third planet gear 27 can be: one large planet gear and two small planet gears with equal diameter; or it can be three planet gears with different diameters, wherein the planet gears are arranged in an unequal circular distribution.

An output shaft 9 is fixedly arranged on a top of the second planet carrier 16, and an external circlip 18 is fixedly installed between the output shaft 9 and the planet ring 4.

A motor flange 14 is fixedly provided inside the first cavity 11. The motor 12 is fixedly connected to the motor flange 14, and the output end of the motor 12 is fixedly connected to the center of the sun gear 20.

Specifically, the planet ring 4 acts as a shell, the planet ring 4 is fixed, and the planet assembly rotates. The planet assembly is equipped with an output shaft 9, and two bearings 17 are arranged between the planet assembly and the planet ring 4. The output shaft 9 is fixed with an external circlip 18 to prevent the output shaft 9 from moving in the axial direction. The bottom of the planet ring 4 is provided with an external installation holes 6. The motor 12 is fixed on the motor flange 14, and the output end of the motor 12 is assembled with the sun gear 20. The motor flange 14 is fixed on the planet ring 4, and the motor drive circuit board PCBA board 10 is fixedly installed in the first cavity 11, and the PCBA board 10 is fixed on the planet ring 4. The PCBA board 10, the first planet gear 23, the second planet gear 25, the third planet gear 27, and the planet ring 4 are made of metal or other hard materials, and the surfaces where they contact each other have hardness and wear resistance requirements.

### SECONDE EMBODIMENT

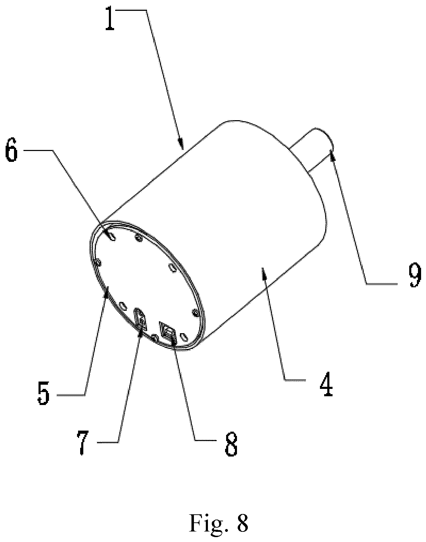

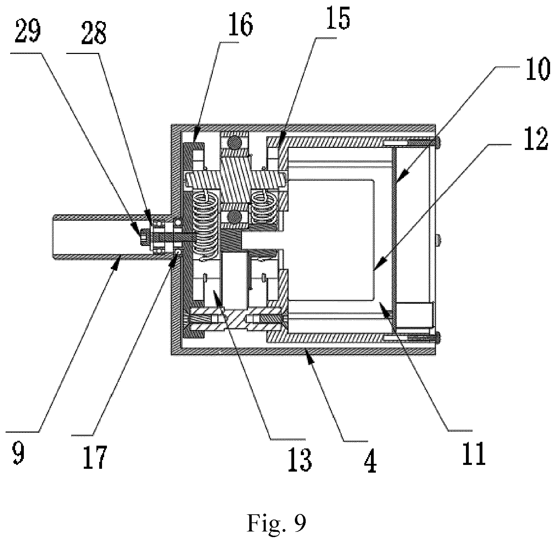

Please refer to Fig. 1 and Fig. 5-9, the present application provides a technical solution for an automobile steering simulator structure:

As shown in Fig. 1 and Fig. 5-9, it comprises a simulator 1, a coupling 2 and a steering wheel 3, wherein the coupling 2 is fixedly connected to an output end of the simulator 1, and the steering wheel 3 is fixedly connected to one end of the coupling 2, wherein a back cover 5 is nested at a bottom of the simulator 1, wherein a plurality of installation holes 6 are equidistantly provided on the sides of the bottom end of the back cover 5, and bolts are threadedly connected inside the plurality of installation holes 6. A DC power interface 7 and a USB interface 8 are arranged in a middle of the back cover 5, wherein a first cavity 11 and a second cavity 13 are fixedly provided inside the simulator, wherein a PCBA board 10 and a motor 12 are fixedly arranged inside the first cavity 11, a planet assembly is fixedly arranged inside the second cavity 13, and the motor 12 is fixedly connected to an input end of the planet assembly, and the DC power interface 7 and USB interface 8 are electrically connected to the PCBA board 10.

The planet assembly consists of a first planet carrier 15, a second planet carrier 16, a planet carrier support column 19 and a planet deceleration mechanism, wherein the plurality of planet carrier support columns 19 are fixed between the first planet carrier 15 and the second planet carrier 16, and the plurality of planet carrier support columns 19 are fixed to the first planet carrier 15 and the second planet carrier 16 by bolts, and a planet reduction mechanism is fixedly arranged between the first planet carrier 15 and the second planet carrier 16.

A planet ring 4 is connected to an outside of the first planet carrier 15 and the second planet carrier 16, wherein two bearings 17 are arranged between the first planet carrier 15, the second planet carrier 16 and the planet ring 4. The planet ring 4 is equipped with an output shaft 9 , and the output shaft 9 and the second planet carrier 16 are assembled through bolts 29.

The planet reduction mechanism comprises a sun gear 20, two tension springs 21, a first transmission shaft 22, a first planet gear 23, a second transmission shaft 24, a second planet gear 25, a third transmission shaft 26 and a third planet gear 27, wherein the sun gear 20 is rotatably connected to a center of the second planet carrier 16, wherein the first transmission shaft 22 and the third transmission shaft 26 that are transitionally assembled and connected to the second planet carrier 16, and the second transmission shaft 24 assembled with a large gap to the second planet carrier 16 are fixed in sequence on sides of the sun gear 20, wherein the first planet gear 23 is rotatably connected to a middle of the first transmission shaft 22, the second planet gear 25 is rotatably connected to a middle of the second transmission shaft 24, and the third planet gear 27 is rotatably connected to a middle of the third transmission shaft 26, wherein a tension spring 21 is fixedly connected between the second transmission shaft 24, the first transmission shaft 22 and the third transmission shaft 26 respectively.

Tension springs 21 are arranged between the first planet gear 23 and the second planet gear 25 and between the second planet gear 25 and the third planet gear 27 to provide a certain preload force between the three planet gears, the sun gear 20 and the planet ring 4, so that the three planet gears, the sun gear 20 and the planet ring 4 contact each other and provide sufficient friction.

The first planet gear 23 , the second planet gear 25, the third planet gear 27 and the sun gear 20 are in contact with each other, and the first planet gear 23 , the second planet gear 25, and the third planet gear 27 have different diameters. The configuration of the first planet gear23, the second planet gear 25 and the third planet gear 27 can be: one large planet gear and two small planet gears with equal diameter; or it can be three planet gears with different diameters, wherein the planet gears are arranged in an unequal circular distribution.

The output shaft 9 is fixedly mounted on the top of the second planet carrier 16 through the cooperation of bolts 29 and washers 28.

The output end of the motor 12 is fixedly connected to the center of the sun gear 20.

Specifically, the planet ring 4 acts as a shell, the planet ring 4 rotates, and the planet assembly is fixed. The planet assembly is equipped with an output shaft 9, and the output shaft 9 and the second planet carrier 16 are assembled through bolts 29, and a gasket 28 is arranged at the connection between the bolt 29 and the second planet carrier 16. Two bearings 17 are arranged between the planet ring 4 and the planet assembly. The motor 12 is fixed on the planet assembly. The output end of the motor 12 is assembled with the sun gear 20. The back cover 5 is fixed on the planet assembly, and external installation holes 6 are provided on the rear side of the planet assembly. The motor drive circuit board PCBA board 10 is fixedly installed in the first cavity 11, and the PCBA board 10 is fixed on the first planet carrier 15. The PCBA board 10 is equipped with an external DC power interface 7 and an external USB interface 8. The first planet gear 23, the second planet gear 25, the third planet gear 27, and the planet ring 4 are made of metal or other hard materials, and the surfaces where they contact each other have hardness and wear resistance requirements.

In the description of the present application, it should be understood that the indicated orientation or positional relationship is based on the orientation or positional relationship shown in the drawings, and is only for the convenience of describing the present application and simplifying the description, but does not indicate or imply that the device or element referred to must have a specific orientation, be constructed and operated in a specific orientation, and therefore cannot be construed as a limitation of the present application.

In the application, unless otherwise clearly stated and limited, for example, it can be a fixed connection, a detachable connection, or an integral part; it can be a mechanical connection or an electrical connection; it can be a direct connection or an indirect connection through an intermediate medium; it can be an internal communication between two elements or the interactive relationship between two elements. Unless otherwise expressly defined, those of ordinary skill in the art can understand the specific meanings of the above terms in the present application according to specific circumstances.

Although the embodiments of the present application have been shown and described, those of ordinary skill in the art will understand that various changes, modifications, substitutions and amendments can be made to these embodiments without departing from the principles and spirit of the application. The scope of the application is defined by the appended claims and their equivalents.

## Claims

1. An automobile steering simulator structure, comprising a simulator (1), a coupling (2) and a steering wheel (3), wherein the coupling (2) is fixedly connected to an output end of the simulator (1), and the steering wheel (3) is fixedly connected to one end of the coupling (2), wherein a back cover (5) is nested at a bottom of the simulator (1), a plurality of installation holes (6) are provided at the bottom of the simulator (1), and a DC power interface (7) and a USB interface (8) are arranged in a middle of the back cover (5), wherein a first cavity (11) and a second cavity (13) are fixedly provided inside the simulator, wherein a PCBA board (10) and a motor (12) are fixedly arranged inside the first cavity (11), a planet assembly is fixedly arranged inside the second cavity (13), and the motor (12) is fixedly connected to an input end of the planet assembly, and the DC power interface (7) and USB interface (8) are electrically connected to the PCBA board (10).

2. The automobile steering simulator structure according to claim 1, wherein the planet assembly consists of a first planet carrier (15), a second planet carrier (16), a planet carrier support column (19) and a planet deceleration mechanism, wherein the plurality of planet carrier support columns (19) are fixed between the first planet carrier (15) and the second planet carrier (16), and the plurality of planet carrier support columns (19) are fixed to the first planet carrier (15) and the second planet carrier (16) by bolts, and a planet reduction mechanism is fixedly arranged between the first planet carrier (15) and the second planet carrier (16).

3. The automobile steering simulator structure according to claim 2, wherein a planet ring (4) is connected to an outside of the first planet carrier (15) and the second planet carrier (16), wherein two bearings (17) are arranged between the first planet carrier (15), the second planet carrier (16) and the planet ring (4).

4. The automobile steering simulator structure according to claim 2, wherein the planet reduction mechanism comprises a sun gear (20), two tension springs (21), a first transmission shaft (22), a first planet gear (23), a second transmission shaft (24), a second planet gear (25), a third transmission shaft (26) and a third planet gear (27), wherein the sun gear (20) is rotatably connected to a center of the second planet carrier (16), wherein the first transmission shaft (22) and the third transmission shaft (26) that are transitionally assembled and connected to the second planet carrier (16), and the second transmission shaft (24) assembled with a large gap to the second planet carrier (16) are fixed in sequence on sides of the sun gear (20), wherein the first planet gear (23) is rotatably connected to a middle of the first transmission shaft (22), the second planet gear (25) is rotatably connected to a middle of the second transmission shaft (24), and the third planet gear (27) is rotatably connected to a middle of the third transmission shaft (26), wherein a tension spring (21) is fixedly connected between the second transmission shaft (24), the first transmission shaft (22) and the third transmission shaft (26) respectively.

5. The automobile steering simulator structure according to claim 4, wherein the tension spring (21) provides a certain preload force between the first planet gear (23), the second planet gear (25), the third planet gear (27) and the sun gear (20), so that they are in contact with each other, and through a friction transmission between them, the power is transmitted from the sun gear (20) to the planet ring (4) or the planet carrier, wherein the first planet gear (23), the second planet gear (25), and the third planet gear (27) have different diameters.

6. The automobile steering simulator structure according to claim 4, wherein an output shaft (9) is fixedly arranged on a top of the second planet carrier (16), and a bearing (17) is arranged between the output shaft (9) and the planet ring (4), wherein an external circlip (18) is arranged axially on the output shaft (9) and the bearing (17).

7. The automobile steering simulator structure according to claim 1, wherein a motor flange (14) is provided inside the first cavity (11) to be fixed to the planet ring (4), the motor (12) is fixedly connected to the motor flange (14), and an output end of the motor (12) is fixedly connected to a center of the sun gear (20).

8. The automobile steering simulator structure according to claim 1, wherein the first planet gear (23), the second planet gear (25), the third planet gear (27), and the planet ring (4) are made of metal or other hard materials, and the surfaces where they contact each other have hardness and wear resistance requirements.
